# EUROPÄISCHE PATENTSCHRIFT

(11) **EP 2 436 087 B1**
(45) Veröffentlichungstag und Bekanntmachung des Hinweises auf die Patenterteilung: **13.07.2016**
(21) Anmeldenummer: 10714269.7
(22) Anmeldetag: 16.04.2010
(51) Int. Cl.: H01R 4/68

(54) **SUPRALEITFÄHIGE VERBINDUNGSEINRICHTUNG DER ENDSTÜCKE ZWEIER SUPRALEITER SOWIE VERFAHREN ZU DEREN HERSTELLUNG**
SUPERCONDUCTIVE CONNECTING DEVICE FOR THE END PIECES OF TWO SUPERCONDUCTORS AND METHOD FOR THE PRODUCTION THEREOF
DISPOSITIF DE CONNEXION SUPRACONDUCTRICE DES ÉLÉMENTS D'EXTRÉMITÉ DE DEUX SUPRACONDUCTEURS ET SON PROCÉDÉ DE FABRICATION

(30) Priorität: 26.05.2009 DE 102009022672
(43) Veröffentlichungstag der Anmeldung: 04.04.2012
(73) Patentinhaber: Siemens Healthcare GmbH, 91052 Erlangen (DE)
(72) Erfinder: OOMEN, Marijn, Pieter, 91056 Erlangen (DE); BIANCHETTI, Marco, Cambridge CB1 1 DR (GB); RABBERS, Jacob, Johan, 91083 Baiersdorf (DE)
(86) Internationale Anmeldenummer: PCT/EP2010/055031
(87) Internationale Veröffentlichungsnummer: WO 2010/136263

(56) Entgegenhaltungen:
- GB-A- 2 448 051

## Beschreibung

Die Erfindung bezieht sich auf eine supraleitfähige Verbindungseinrichtung der Endstücke wenigstens zweier Supraleiter, die jeweils eine Matrix aus normalleitendem Material und mindestens eine darin eingelagerte Leiterader aus supraleitfähigem MgB₂ (Magnesium-Diborid) aufweisen, wobei in einem Verbindungsbereich in einer Hülse oder Buchse
- die Leiteradern der Endstücke zumindest teilweise von dem Matrixmaterial entkleidet angeordnet sind und
- zusätzlich als ein supraleitfähiges Kontaktierungsmaterial MgB₂ vorhanden ist, das sich zumindest in Teilbereichen zwischen den Leiteradern befindet.

Eine entsprechende supraleitfähige Verbindungseinrichtung sowie ein Verfahren zur Herstellung dieser Verbindungseinrichtung gehen aus der WO 2007/128635 A1 hervor.

Supraleiter unter Verwendung von LTC(Low-T_{c})-Supraleitermaterial oder HTC(High-T_{c})-Supraleitermaterial werden unter anderem als so genannte Einkernleiter oder Multifilamentleiter in begrenzter Leiterlänge hergestellt. Bei einem entsprechenden Leiteraufbau solcher Leiter ist die mindestens eine supraleitfähige Leiterader (oder das mindestens eine supraleitfähige Leiterfilament) in eine Matrix aus normalleitendem Material eingebettet. Insbesondere bei der Erstellung von supraleitfähigen Einrichtungen mit solchen Supraleitern wie z.B. Magnetwicklungen ist eine Kontaktierung bzw. Verbindung von Endstücken entsprechender Leiter erforderlich.

Manche supraleitenden Magnetwicklungen, z. B. für Magnetresonanz-Tomographen (auch als "Kernspin- oder NMR-Tomographen" bezeichnet), müssen im so genannten "Dauerstrom-Modus" (englisch: "persistent current mode") betrieben werden. Dazu wird die Magnetwicklung kurzgeschlossen und der einmal eingestellte Magnetstrom fließt ohne Stromquelle praktisch zeitlich unbegrenzt weiter. Dies macht jedoch erforderlich, dass der stromdurchflossene Kreis der Magnetwicklung praktisch keinen elektrischen Widerstand besitzt. Dazu sind auch supraleitfähige Verbindungen zwischen einzelnen supraleitfähigen Leitern (Supraleitern) notwendig. Diese supraleitfähigen Verbindungen reagieren jedoch empfindlich auf magnetische Felder. Übersteigt nämlich das magnetische Feld bzw. die magnetische Induktion einen gewissen Grenzwert, der typischerweise zwischen 1 Tesla und 2 Tesla liegt, so zeigt die Verbindung einen elektrischen Widerstand und macht somit einen DauerstromBetrieb unmöglich. Bei supraleitenden Hochfeldmagneten, deren magnetische Induktion z. B. bei 3 Tesla oder darüber liegt, führt dies zu Problemen, da man die Verbindungen an Stellen anbringen muss, bei denen das lokale Magnetfeld unterhalb des genannten Grenzwertes liegt. Bei sehr hohen Feldern kann es sogar unmöglich werden.

Eine bekannte supraleitfähige Verbindung der Endstücke zweier Supraleiter geht z. B. aus "IEEE Transactions on Applied Superconductivity", Vol. 9, No. 2, Juni 1999, Seiten 185 bis 187 hervor. Zur Herstellung dieser Verbindung werden an den zu verbindenden Endstücken der Supraleiter deren Filamente z. B. durch Ätzen freigelegt und dann mit Hilfe eines supraleitfähigen Lots als einem Kontaktierungsmaterial miteinander verbunden. Als Lote kommen in der Regel Blei-Verbindungen zum Einsatz wie z. B. aus der Legierung Pb27-Bi50-Sn12-Cd10 (so genanntes "Woods-Metall") oder ähnliche Lote auf Pb-Bi- oder Pb-Bi-Sn-Legierungsbasis. Alle diese Lotmaterialien haben ein oberes kritisches Magnetfeld B_{c2} von höchstens etwa 2 Tesla bei einer Temperatur von 4,2 K, der Temperatur des flüssigen Heliums bei Normaldruck. Bei Feldern oberhalb dieses kritischen Magnetfeldes verlieren sie ihre supraleitfähigen Eigenschaften und sind deshalb häufig nicht zur Ausbildung von supraleitfähigen Hochfeldkontakten geeignet.

Eine weitere Verbindungstechnik für die Endstücke zweier Supraleiter ist aus "Cryogenics", Vol. 30 (Supplement), 1990, Seiten 626 bis 629 zu entnehmen. Hier werden die Supraleiter mittels Punktschweißens oder auch Diffusionsbondens direkt ohne ein kontaktvermittelndes/-förderndes Zwischenmaterial durch Anwendung von Druck und Temperatur miteinander verbunden bzw. verpresst. Die Stromtragfähigkeit entsprechender Verbindungen ist jedoch in der Regel geringer als die des Leiters selbst. Dabei tritt das Problem auf, dass die Filamente keine großflächigen Kontakte sondern eher Punktkontakte eingehen. Mit zunehmenden Magnetfeldstärken sinkt dann jedoch die Stromtragfähigkeit weiter, so dass auch Verbindungen dieser Art nicht für viele supraleitfähigen Hochfeldkontakte geeignet sind.

Aus der DE 34 13 167 A1 ist ein Verfahren zur Herstellung eines supraleitfähigen Kontaktes zwischen Supraleitern zu entnehmen, bei dem an Leiterendstücken aus einem Leitervorprodukt die vom Matrixmaterial befreiten Leiteradern zusammen mit einem bestimmten Pulvermaterial als Zwischenmaterial in einer Hülse einer Druck- und Temperaturbehandlung unterzogen werden. Das Pulvermaterial ist dabei so gewählt, dass mit ihm bei dieser Behandlung wie auch aus dem Leitervorprodukt supraleitfähiges Material ausgebildet wird. Dabei sind jedoch hohe Temperaturen von beispielsweise über 600°C erforderlich. Das bekannte Verfahren ist deshalb sehr aufwendig und vielfach nicht einsetzbar.

Aus der WO 2007/128635 A1 ist eine supraleitfähige Verbindung von Endstücken zweier Supraleiter und ein Verfahren zu deren Herstellung bekannt, bei welcher die Verbindung unter 600°C durch Verwendung von MgB₂ hergestellt werden kann. Dabei werden Ätzschritte verwendet, bei denen ein Matrixmaterial entfernt wird, in welchem die MgB₂ Leiteradern eingebettet sind. Bei dem Ätzschritt, bei dem das MgB₂-Material freigelegt wird und mit der Umgebungsatmosphäre reagieren kann, degradiert das MgB₂-Material und wird brüchig. Es kann nach dem Ätzschritt zerbröckeln, was eine Verbindung der Endstücke erschwert bzw. unmöglich macht.

Aus der GB 2 448 051 A ist eine Verbindungseinrichtung und ein Verfahren zu deren Herstellung bekannt, bei welchen Kabel mit supraleitfähigen MgB₂-Leitern an Endstücken zusammengefügt werden. Die supraleitfähigen MgB₂-Leitern werden von einem Matrix- und Barrierematerial mechanisch oder chemisch entkleidet. Beim Entkleiden können die supraleitfähigen MgB₂-Leiter beschädigt werden, was insbesondere bei Hochfeldbedingungen zu Problemen führen kann.

Aufgabe der vorliegenden Erfindung ist es, eine Verbindung bzw. eine Verbindungseinrichtung zwischen supraleitfähigen MgB₂-Leitern an Endstücken zu schaffen, die einerseits hohe magnetische Induktionen von oberhalb 1 Tesla und insbesondere oberhalb von 2 Tesla ohne Degradation ihrer Stromtragfähigkeit ermöglichen und andererseits auf einfache Weise herstellbar sind. Insbesondere ist es Aufgabe, eine Verbindung zwischen supraleitfähigen MgB₂-Leitern an Endstücken zu schaffen, welche den Einsatz der Verbindungseinrichtung unter Hochfeldbedingungen ermöglicht. Außerdem soll ein geeignetes Verfahren zur einfachen Herstellung entsprechender Verbindungen angegeben werden, bei welchem eine Schädigung der MgB₂-Leiteradern durch Ätzschritte verringert bzw. vollständig verhindert werden und ein Zerbröseln der Endstücke nicht oder vermindert auftritt.

Die sich auf die supraleitfähige Verbindungseinrichtung der eingangs genannten Art beziehende Aufgabe wird mit den in Anspruch 1 angegebenen Maßnahmen gelöst. Demgemäß sind die MgB₂-Leiteradern mit einer Barrierenschicht unmittelbar ummantelt und in einem normalleitenden Matrixmaterial eingebettet, wobei das Material der Barrierenschicht und das Matrixmaterial unterschiedlich sind. Die Leiteradern der Endstücke sind zumindest teilweise von dem Matrixmaterial entkleidet und das Barrierenmaterial ist zumindest in einem stirnseitigen Verbindungsbereich der Leiteradern nicht vorhanden. Die Ummantelung mit der Barrierenschicht ist jeweils in einem Teilbereich der von Matrixmaterial entkleideten Endstücke der Leiteradern vorhanden. Supraleitfähiges Kontaktierungsmateri al MgB₂ ist in einer Hülse oder Buchse zumindest in Teilbereichen zwischen den Leiteradern in dem Verbindungsbereich vorhanden.

Die mit dieser Ausgestaltung der supraleitfähigen Verbindungseinrichtung verbundenen Vorteile sind insbesondere darin zu sehen, dass die Verbindungseinrichtung
- im Wesentlichen keine degradierten Endstücke der MgB₂ Leiteradern aufweist,
- was einen Einsatz auch in hohen Magnetfeldern möglich macht, und
- was einfach und kostengünstig herzustellen ist, ohne durch Ätzschritte die MgB₂ Leiteradern zu degradieren bis hin zum zerbröckeln der Leiteradern, wobei
- im Allgemeinen nur ein Spülen, Schleifen und Polieren sowie Verpressen der zu verbindenden Endstücke erforderlich ist, so dass vielfach auf eine besondere Temperaturbehandlung verzichtet werden kann, und wobei
- sich supraleitende Verbindungseinrichtungen ergeben, welche sich robust und stabil insbesondere gegenüber Flusssprüngen verhalten,
- und außerdem eine unter Umweltgesichtspunkten bedenkliches Ätzen nicht zwingend erforderlich ist.

Der Einsatz entsprechender Verbindungseinrichtungen in supraleitenden Magneten ermöglicht einen Dauerstrombetrieb in hohen Magnetfeldern, wie er z. B. für Hochfeldmagnete in Magnetresonanz-Tomographen gefordert wird.

Vorteilhafte Ausgestaltungen der erfindungsgemäßen supraleitfähigen Verbindungseinrichtung gehen aus den von Anspruch 1 abhängigen Ansprüchen hervor. Dabei kann die Ausführungsform nach Anspruch 1 mit den Merkmalen eines der Unteransprüche oder vorzugsweise auch denen aus mehreren Unteransprüchen kombiniert werden.

Demgemäß kann die Verbindungseinrichtung nach der Erfindung zusätzlich noch folgende Merkmale aufweisen:
- So wird eine größere Fläche des supraleitenden MgB₂-Verbindungsbereichs der Endstücke erreicht durch Anschrägen der Endstücke.
- Es wird bevorzugt ein Betrieb bei einer Temperatur unterhalb der Sprungtemperatur von 39 K des MgB₂-Kontaktierungsmaterials vorgesehen. Die supraleitenden Eigenschaften des gesamten Aufbaus innerhalb der Hülse oder Buchse sind so zu gewährleisten.
- Insbesondere ist eine Betriebstemperatur bei der Temperatur des flüssigen Heliums von etwa 4,2 K vorzusehen, die den Einsatz bekannter Einrichtungen der Supraleitungstechnik ermöglicht.
- Dabei kann das Matrixmaterial aus Kupfer oder Nickel bestehen, oder diese Materialien bzw. Verbindungen dieser Materialien enthalten. Kupfer und Nickel lassen sich besonders einfach auch ohne Ätzen in einem Zinnbad entfernen.
- Das Barrierenmaterial kann aus Stahl oder Edelstahl bestehen oder diese enthalten. Dadurch wird gewährleistet, dass beim Entfernen des Matrixmaterials die Leiteradern aus MgB₂ im Wesentlichen nicht angegriffen werden und nicht degradieren. Stahl und insbesondere Edelstahl sind in einem Zinnbad beständig und lösen sich nicht auf.
- Besonders vorteilhaft kann die supraleitfähige Verbindung einer supraleitfähigen Magnetwicklung eines Magneten wie insbesondere von einer Anlage zur Magnetresonanz-Tomographie zugeordnet sein. Denn der Aufbau von Magneten insbesondere für Hochfeldanwendungen erfordert supraleitende Verbindungen mit hoher Stromtragfähigkeit in den Magnetfeldern. Das MgB₂-Kontaktierungsmaterial mit unbeschädigten, nicht degradierten Leiteradern aus MgB₂ gewährleisten entsprechende Anwendungen.
- Wegen dieser Eigenschaft ist die supraleitfähige Verbindung besonders für eine für einen Dauerstrombetrieb ausgelegte supraleitfähige Magnetwicklung geeignet.

Die sich auf das Verfahren beziehende Aufgabe wird mit den in Anspruch 10 aufgeführten Maßnahmen gelöst. Demgemäß soll bzgl. der beanspruchten supraleitfähigen Verbindungseinrichtung vorgesehen werden,
- dass an den zu verbindenden Endstücken die supraleitfähigen Leiteradern jeweils zumindest teilweise von ihrem Matrixmaterial entkleidet werden,
- dass bei dem Entkleidungsvorgang das ummantelnde Barrierenmaterial nicht entfernt wird,
- im Verbindungsbereich an den Stirnseiten der zu verbindenden Endstücke das MgB₂-Material der Leiteradern zumindest teilweise freigelegt wird oder ist,
- dass die so entkleideten Leiteradern in die Hülse oder Buchse eingebracht werden,
- dass in die Hülse oder Buchse zusätzlich das MgB₂-Kontaktierungsmaterial eingebracht wird und
- dass der Querschnitt der so gefüllten Hülse oder Buchse reduziert wird.

Das Verfahren zeichnet sich insbesondere durch seine Einfachheit aus. Denn allein die Querschnittsreduzierung reicht vorteilhaft in vielen Fällen schon aus, um die gewünschte Verbindung zu schaffen, die auch einen Einsatz unter Hochfeldbedingungen ermöglicht.

Insbesondere die Barriereschicht gewährleistet dabei beim Entkleiden der Leiteradern vom Matrixmaterial, dass das MgB₂ Material der Leiteradern, welches von dem Barrierenmaterial umgeben ist, nicht angegriffen wird und somit nicht degradiert. Nach dem Entkleidungsvorgang wird das MgB₂-Material der Leiteradern zumindest an den Stirnseiten der zu verbindenden Endstücke zumindest teilweise freigelegt, oder das zuvor bereits freigelegte MgB₂-Material wird von dem Entkleidungsvorgang abgeschirmt. Mit Hilfe des in die Hülse oder Buchse eingebrachten MgB₂-Kontaktierungsmaterials ergeben sich besonders gute supraleitende elektrische Kontakte beim reduzieren des Querschnitts der Hülse oder Buchse.

Vorteilhafte Ausgestaltungen des Verfahrens zur Herstellung der supraleitfähigen Verbindungseinrichtung gehen aus den von Anspruch 10 abhängigen Ansprüchen hervor. Dabei kann die Ausführungsform nach Anspruch 10 mit den Merkmalen eines der davon abhängigen Unteransprüche oder vorzugsweise auch denen aus mehreren Unteransprüchen kombiniert werden. Demgemäß kann das Verfahren zusätzlich noch folgende Merkmale aufweisen:
- Die Endstücke mit dem supraleitfähigen MgB₂ und dem Barrierenmaterial werden vor dem Einbringen in die Hülse oder Buchse angeschrägt, derart dass die Fläche der freiliegenden MgB₂-Verbindungsbereiche vergrößert wird. Durch die vergrößerte Fläche ergeben sich bessere Kontakte mit höherer Stromtragfähigkeit.
- Die Verbindungsbereiche werden zumindest teilweise geschliffen und/oder poliert. Dadurch werden in einfacher Form die Flächen der Verbindungsbereiche vergrößert und eventuell an den Enden der Leiteradern geschädigte MgB₂-Bereiche entfernt.
- Das Matrixmaterial wird in einem Zinnbad entfernt, wobei die Leiteradern von dem Barrierematerial ummantelt bleiben. Dadurch kann der Ätzschritt eingespart werden, wobei das Barrierematerial weiterhin das MgB₂-Material der Leiteradern schützt.
- Das MgB₂-Kontaktierungsmaterial wird in die Hülse oder Buchse in Pulverform eingebracht. Es lässt sich so ein kompakter Aufbau mit intensiver Kontaktierung zwischen dem supraleitfähigen Teilen und dem Kontaktierungsmaterial erreichen.
- Die gefüllte Hülse oder Buchse wird nach oder während der Querschnittsreduzierung einer Wärmebehandlung unterzogen. Damit lässt sich der Verbundaufbau aus den verschiedenen Materialien weiter verbessern, insbesondere im Hinblick auf die Stromtragfähigkeit bei hohen Magnetfeldern.
- Dafür lässt sich die Wärmebehandlung bei einer Temperatur von unter 600°C, vorzugsweise unter 250°C vornehmen. Gerade eine Wärmebehandlung bei der verhältnismäßig niedrigen Temperatur ist mit einfachen Mitteln zu realisieren.
- Die Wärmebehandlung lässt sich in Argon-Atmosphäre durchführen. Dadurch kann das Eindringen von Sauerstoff und Wasser in das MgB₂-Material verhindert werden, was dieses Material degradieren lässt und zu verschlechterten supraleitenden Kontakten führt. Das Verfahren lässt sich in Argon einfacher als in Vakuum durchführen, da ein Eindringen von Sauerstoff und Wasser in den Ofen für die Wärmebehandlung verhindert leichter bzw. mit weniger Aufwand wird.

Zur weiteren Erläuterung der Erfindung wird nachfolgend auf die Figuren Bezug genommen, an Hand derer bevorzugte Ausführungsbeispiele einer supraleitfähigen Verbindungseinrichtung nach der Erfindung weiter beschrieben sind. Dabei zeigen in stark schematisierter Darstellung:
- Fig. 1: einen Querschnitt durch einen bekannten MultifilamentSupraleiter nach dem Stand der Technik,
- Fig. 2: einen Längsschnitt durch eine erste Ausführungsform eines Multifilament-Supraleiters, wie er für die erfindungsgemäße Verbindungseinrichtung Verwendung findet,
- Fig. 3: einen Längsschnitt durch eine zweite Ausführungsform eines Multifilament-Supraleiters,
- Fig. 4: einen teilweise ausgeführten Schnitt durch einen Aufbau einer ersten Ausführungsform einer erfindungsgemäßen Verbindungseinrichtung von Multifilament-Supraleitern,
und
- Fig. 5: den Aufbau einer weiteren Ausführungsform einer solchen Verbindungseinrichtung in Figur 4 entsprechender Darstellung.

Dabei sind in den Figuren sich entsprechende Teile jeweils mit denselben Bezugszeichen versehen.

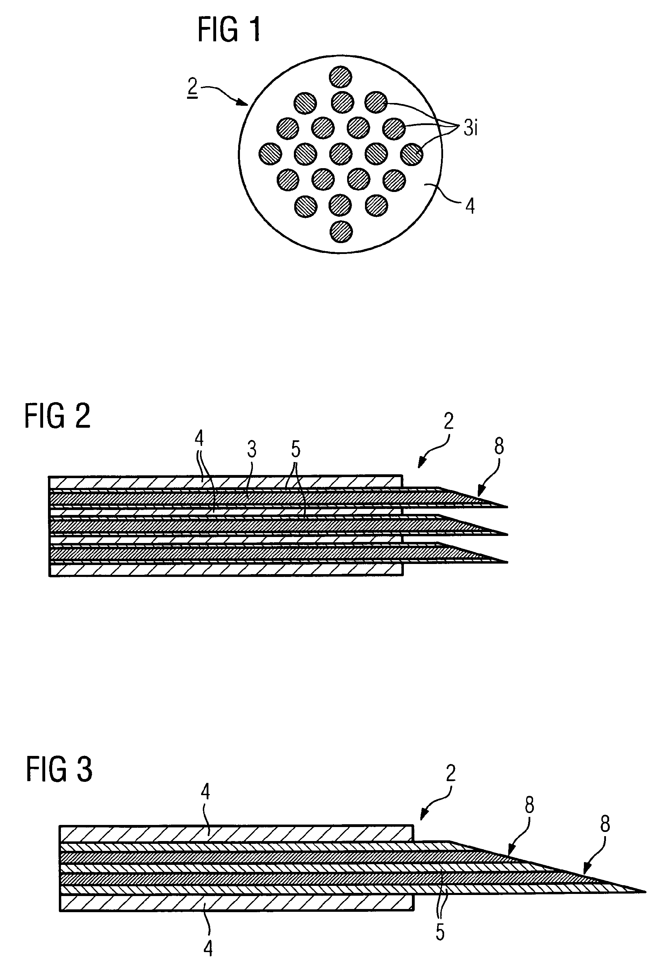

Bei dem in Figur 1 gezeigten Supraleiter wird von bekannten Ausführungsformen ausgegangen. Dabei kann es sich um so genannte Einkern(Monocore)-Supraleiter oder aber, wie für die Figur angenommen, um so genannte Multifilament-Supraleiter handeln. Ein solcher Supraleiter 2 weist mehrere supraleitfähige Leiteradern oder Filamente 3i auf, die in eine Matrix 4 aus normalleitendem Material eingebettet sind. Die Leiteradern 3i sind aus MgB₂ HTC-Supraleitermaterial. Für die Matrix bekannte Materialien sind entweder elementar (wie z. B. Cu, Ni, Ag, Fe, Wo, Al) oder Legierungen, insbesondere dieser Elemente (wie z. B. CuNi, AgMg, CuSn, CuZn oder NiCr).

In Fig. 2 ist ein Supraleiter 2 als Schnitt entlang seiner Längsachse gezeigt, wie er in der erfindungsgemäßen Verbindungseinrichtung Verwendung findet. Der Supraleiter 2 kann analog dem Supraleiter 2 in Fig. 1 ausgebildet sein, oder aus übereinander gestapelten Bandleitern als Leiteradern 3i aufgebaut sein. Im Unterschied zu dem in Fig. 1 dargestellten Supraleiter 2 sind die supraleitenden Leiteradern 3i des in Fig. 2 dargestellten Supraleiters 2 mit einem Barrierenmaterial 5 ummantelt. Das Barrierenmaterial 5 kann zum Beispiel aus Stahl oder Edelstahl bestehen. Es sind aber auch weitere stabile Metalle wie Niobium Nb als Barrierenmaterial 5 einsetzbar.

Die Leiteradern 3i sind an ihren stirnseitigen Enden vorzugsweise angeschrägt. Die angeschrägten Enden bilden den stirnseitigen Verbindungsbereich 8. Der Verbindungsbereich 8 kann geschliffen und/oder poliert werden. Dadurch wird MgB₂-Material der Leiteradern 3i abgetragen bzw. freigelegt, welches zum Beispiel durch das Entfernen des Matrixmaterials 4 geschädigt wurde. Durch das Barrierenmaterial 5 wird eine Schädigung und ein zerbröseln weiteren MgB₂-Materials der Leiteradern während des Entfernens des Matrixmaterials 4 und danach verhindert. Die so freigelegten, geschliffenen und/oder polierten Verbindungsbereiche 8 ergeben sehr gute supraleitende Kontakte in der erfindungsgemäßen Verbindungseinrichtung.

Gegebenenfalls ist es aber auch möglich, bereits vor dem Entkleidungsvorgang bzgl. des Matrixmaterials 4 zumindest die Stirnseiten der Leiteradern 3i freizulegen. Dann müssen aber diese freigelegten Teile der Leiteradern bei dem Entkleidungsvorgang durch besondere Maßnahmen vor dem Entkleidungs- bzw. Ätzmittel geschützt werden.

Die Leiteradern 3i können im Superleiter 2 wie in Fig. 2 gezeigt getrennt vorliegen, mit Matrixmaterial 4 zwischen den einzelnen Leiteradern 3i, oder sie können wie es in Fig. 3 dargestellt wird, zusammenhängend als ein Block ausgebildet sein. Die Ausbildung der Leiteradern 3i zusammenhängend erleichtert das Schleifen und/oder Polieren der Enden der Leiteradern 3i.

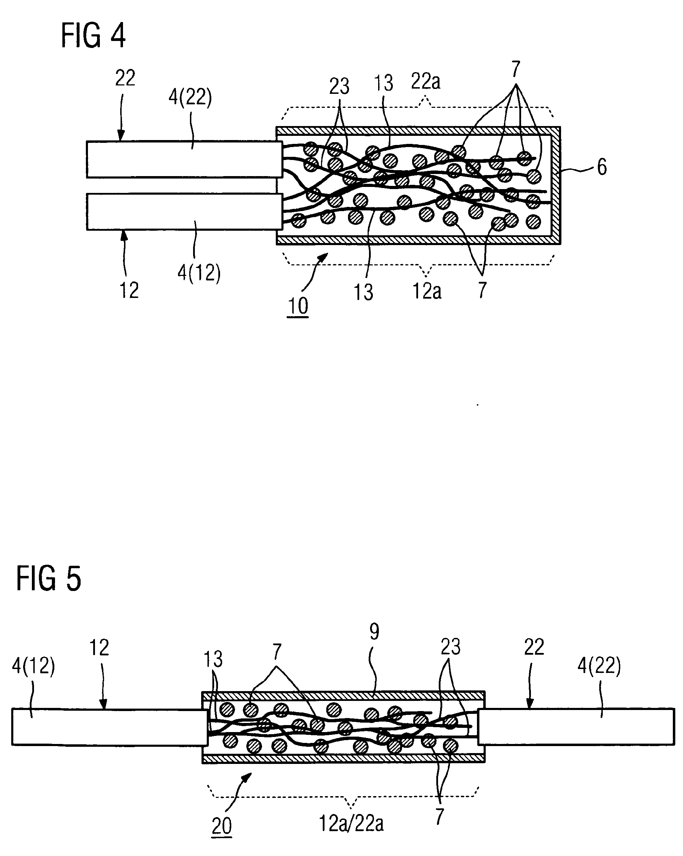

Fig. 4 zeigt mindestens zwei Endstücke von Supraleitern 2, die den in Fig. 2 oder 3 dargestellten Supraleitern 2 entsprechen, welche miteinander mit einer erfindungsgemäßen Verbindungseinrichtung widerstandsarm kontaktiert sind. Vor dem Kontaktieren muss im Bereich der Endstücke der Supraleiter 2 mindestens eine supraleitfähige Leiterader 3i zumindest teilweise freigelegt, d.h. von dem Matrixmaterial mittels hierfür bekannter Techniken wie z. B. durch chemisches Ätzen, mechanisches Abtragen, insbesondere schräges Anschleifen, zumindest teilweise entkleidet werden.

Dabei werden die Leiteradern 3i durch das Barrierematerial 5 geschützt. Ein Zerbröseln des MgB₂-Materials wird durch das Barrierematerial 5 verhindert. Besonders vorteilhaft ist das Spülen der Enden der Leiteradern 3i in einem Zinnbad, wenn das Matrixmaterial 4 sich in Zinn auflöst. Dies ist zum Beispiel gegeben, wenn das Matrixmaterial 4 aus Kupfer besteht. Das Entfernen des Matrixmaterials 4 mit Hilfe eines Zinnbades erspart einen Ätzvorgang. Bei Verwendung von Stahl oder Edelstahl als Barrierematerial 5 wird ein Auflösen des Barrierematerials 5 im Zinnbad verhindert und das Barrierematerial 5 schütz beim Spülen in Zinn das MgB₂-Material. Die Leiteradern 3i werden so nicht geschädigt.

Beim Anschrägen der Leiteradern 3i durch Schleifen und/oder Polieren wird an den stirnseitigen Enden der Leiteradern 3i ein Verbindungsbereich geschaffen. Im Verbindungsbereich ist das Barrierematerial 5 entfernt und ungeschädigtes MgB₂-Material liegt für die Kontaktierung der Leiteradern 3i vor.

In Fig. 4 sind zwei Supraleiter 12 und 22 dargestellt, welche an ihren Enden über eine erfindungsgemäße Verbindungseinrichtung supraleitend kontaktiert werden. Dabei sind mit 12a bzw. 22a deren Endstücke und ihre dort entsprechend vollständig freigelegten Leiteradern mit 13 bzw. 23 bezeichnet. Die Leiteradern sind in eine Buchse 6 oder Hülse (vgl. Figur 5) zusammen mit einem MgB₂-Kontaktierungsmaterial 7, welches zum Beispiel in Pulverform vorliegt, eingebracht. Unter einer Buchse oder Hülse sei hier allgemein wenigstens ein beliebiges, die Leiteradern 13 bzw. 23 und das Kontaktierungsmaterial 7 in bekannter Weise aufnehmendes und zumindest teilweise umhüllendes Element zu verstehen, über das sich eine Komprimierung bzw. Querschnittsverringerung der in es eingebrachten Teile vornehmen lässt.

Das erfindungsgemäß als Kontaktierungsmaterial zur Anwendung kommende Magnesium-Diborid (MgB₂) ist ein supraleitfähiges Material mit einer kritischen Temperatur von etwa T_{c} = 39 K (bei Normaldruck) und einem oberen kritischen Feld B_{c2} (bei 4,2 K) von über 40 Tesla. Es ist damit auch für den Einsatz in hohen Magnetfeldern geeignet, wie sie z. B. in Hochfeldmagneten insbesondere von Magnetresonanz-Tomographen auftreten. Bevorzugt wird deshalb die Verbindung nach der Erfindung unter Verwendung des MgB₂-Kontaktierungsmaterials bei Temperaturen von unter 39 K, beispielsweise bei 4,2 K, betrieben, wobei bekannte Kühltechniken wie z. B. mit flüssigem Helium zum Einsatz kommen. MgB₂ ist kommerziell als Pulver beziehbar. Es ist in der Lage, durch geeignetes Verpressen oder Walzen auch ohne eine Temperaturbehandlung bzw. Glühung einen supraleitfähigen Strom zu tragen (vgl. "Applied Physics Letters", Vol. 79, 2001, Seiten 230 bis 233). Wegen seiner verhältnismäßig hohen kritischen Temperatur ist dieses Material auch gegen Störungen wie z. B. Flusssprünge oder Leiterbewegungen oder unerwünschte Erhöhungen der Betriebstemperatur, die zu einem so genannten Quenchen führen, besonders unempfindlich.

Die mit den freigelegten Leiteradern 13 und 23 sowie mit dem pulverförmigen MgB₂-Kontaktierungsmaterial 7 zu füllende Buchse 6 besteht vorzugsweise aus einem metallischen Material, das gut verformbar ist. Geeignete Materialien hierfür sind elementare Materialien wie z. B. Cu, Ni, Ag, Nb, oder Fe sowie Legierungen wie z. B. Stähle, NbTi, NiCr oder CuZn. In der Buchse 6 werden insbesondere in den Bereichen, wo die Leiteradern 13 und 23 nicht unmittelbar aneinander zu liegen kommen, die Zwischenräume zwischen den Leiteradern mit den MgB₂-Pulverpartikeln 7, von denen in der Figur aus Gründen der Übersichtlichkeit nur einige veranschaulicht sind, ausgefüllt. Die Ausbildung des gewünschten Kontaktes zwischen den Leiteradern wird dann durch eine querschnittsverringernde Bearbeitung zumindest des Bereichs der zu verbindenden Leiterendstücke wie durch Verpressen oder Walzen vorgenommen. Gegebenenfalls kann noch diese Kontaktierungsmaßnahme mittels einer Glühung, vorzugsweise bei verhältnismäßig niedrigen Temperaturen von unter 250°C verbessert werden. Selbstverständlich sind gegebenenfalls auch höhere Glühtemperaturen bis 600°C und darüber anwendbar (vgl. z. B. "IEEE Transaction on Applied Superconductivity", Vol. 15, No. 2, Juni 2005, Seiten 3211 bis 3214). Die so zu erhaltende Verbindung ist in der Figur allgemein mit dem Bezugszeichen 10 versehen.

Eine weitere, in Figur 5 veranschaulichte Ausführungsform einer supraleitfähigen, allgemein mit 20 bezeichneten Verbindung unterscheidet sich von der supraleitfähigen Verbindung 10 nach Figur 4 dadurch, dass hier die beiden supraleitfähigen Leiter 12 und 22 dadurch kontaktiert werden, dass ihre im Bereich ihrer Endstücke 12a und 22a freigelegten Leiteradern 13 und 23 gegenläufig in eine Hülse 9 zusammen mit den MgB₂-Pulverpartikeln 7 eingebracht und dort verpresst werden.

Bei den in den Figuren 4 und 5 schematisch dargestellten Ausführungsformen von supraleitenden Verbindungen bzw. Verbindungseinrichtungen 10 bzw. 20 wurde davon ausgegangen, dass an den Endstücken 12a und 22a der Supraleiter 12 bzw. 22 jeweils das Material der Matrix 4 vollständig entfernt wurde. Gegebenenfalls ist es jedoch auch möglich, dass man nur einen Teil, z. B. den halben Querschnitt, der Leiter im Bereich ihrer Endstücke von dem Matrixmaterial 4 auf mechanischem oder chemischem Wege befreit, so dass dann an einer Oberfläche des verbleibenden Aufbaus einige der Leiteradern freigelegt sind (vgl. z. B. EP 0 556 837 A1). Die so freigelegten Oberflächen zweier Leiterendstücke werden dann unter Einfügung des MgB₂-Kontaktierungsmaterials in der beschriebenen Weise aneinander gefügt und miteinander verbunden.

Außerdem wurde für die Darstellung nach den Figuren 4 und 5 angenommen, dass jeweils nur zwei Supraleiter 12 und 13 an ihren Endstücken 12a und 13a miteinander elektrisch verbunden werden. Selbstverständlich können in eine Buchse 6 oder eine Hülse 9 auch eine darüber hinausgehende Anzahl von Endstücken, z.B. von drei Supraleitern, eingebracht und dort miteinander verbunden werden.

In der Beschreibung wurde von MgB₂ als Kontaktierungsmaterial 7 ausgegangen. Es können aber auch Ausgangsmaterialien von MgB₂, z.B. Mg- und Br-Prekurser-Materialien verwendet werden. Durch Glühung wird in bekannter Weise die supraleitende Phase bei Verwendung von Prekurser-Materialien ausgebildet.

## Patentansprüche

1. Supraleitfähige Verbindungseinrichtung der Endstücke wenigstens zweier Supraleiter (2), die jeweils eine Matrix (4) aus normalleitendem Material und mindestens eine darin eingelagerte Leiterader (3i) aus supraleitfähigem MgB₂ (Magnesium-Diborid) aufweisen, wobei in einem Verbindungsbereich (8) in einer Hülse (6) oder Buchse (9)
- die Leiteradern (3i) der Endstücke zumindest teilweise von dem Matrixmaterial (4) entkleidet angeordnet sind
und
- zusätzlich als ein supraleitfähiges Kontaktierungsmaterial (7) MgB₂ oder dessen Ausgangsmaterialien vorhanden ist, das sich zumindest in Teilbereichen zwischen den Leiterädern (3i) befindet,
wobei
- die Leiteradern (3i) unmittelbar ummantelt sind jeweils von einer Barrierenschicht aus einem von dem Matrixmaterial (4) verschiedenen Barrierenmaterial (5),
und
- zumindest ein stirnseitiger Verbindungsbereich (8) von dem Barrierenmaterial (5), welches die Leiteradern (3i) umgibt, freigehalten ist,
**dadurch gekennzeichnet, dass**
- die Ummantelung mit der Barrierenschicht jeweils in einem Teilbereich der von Matrixmaterial (4) entkleideten Endstücke der Leiteradern (3i) vorhanden ist.

2. Supraleitfähige Verbindungseinrichtung nach Anspruch 1, **dadurch gekennzeichnet, dass** die Endstücke mit dem supraleitfähigem MgB₂ und dem Barrierenmaterial (5) angeschrägt sind.

3. Supraleitfähige Verbindungseinrichtung nach Anspruch 1 oder 2, **gekennzeichnet durch** einen Betrieb bei einer Temperatur unterhalb der Sprungtemperatur von 39 K des MgB₂-Kontaktierungsmaterials (7).

4. Supraleitfähige Verbindungseinrichtung nach Anspruch 3, **gekennzeichnet durch** eine Betriebstemperatur bei der Temperatur des flüssigen Heliums von etwa 4,2 K.

5. Supraleitfähige Verbindungseinrichtung nach einem der vorangehenden Ansprüche, **dadurch gekennzeichnet, dass** das Matrixmaterial (4) aus Kupfer oder Nickel besteht, oder dass das Matrixmaterial (4) Kupfer oder Nickel enthält und/oder die Hülse (6) oder Buchse (9) luft- und/oder wasserdicht versiegelt ist.

6. Supraleitfähige Verbindungseinrichtung nach einem der vorhergehenden Ansprüche, **dadurch gekennzeichnet, dass** das Barrierenmaterial (5) aus Stahl oder Edelstahl besteht oder Stahl Edelstahl enthält.

7. Supraleitfähige Verbindungseinrichtung nach einem der vorangehenden Ansprüche, **gekennzeichnet durch** eine Zuordnung zu einer supraleitfähigen Magnetwicklung eines Magneten.

8. Supraleitfähige Verbindungseinrichtung nach Anspruch 7, **gekennzeichnet durch** eine Zuordnung zu einer supraleitfähigen Magnetwicklung eines Magneten einer Anlage zur Magnetresonanz-Tomographie.

9. Supraleitfähige Verbindungseinrichtung nach Anspruch 7 oder 8, **gekennzeichnet durch** eine Zuordnung zu einer für einen Dauerstrombetrieb ausgelegten supraleitfähigen Magnetwicklung.

10. Verfahren zur Herstellung einer supraleitfähigen Verbindungseinrichtung nach einem der vorangehenden Ansprüche, **dadurch gekennzeichnet,**
- **dass** an den zu verbindenden Endstücken die supraleitfähigen Leiteradern (3i) jeweils zumindest teilweise von ihrem Matrixmaterial (4) entkleidet werden,
- **dass** bei dem Entkleidungsvorgang das Barrierenmaterial (5) nicht entfernt wird,
- **dass** im Verbindungsbereich (8) zumindest an den Stirnseiten der zu verbindenden Endstücke das MgB2-Material der Leiteradern (3i) zumindest teilweise freigelegt wird oder ist,
- **dass** die so entkleideten Leiteradern (3i) in die Hülse (6) oder Buchse (9) eingebracht werden,
- **dass** in die Hülse (6) oder Buchse (9) zusätzlich das MgB₂-Kontaktierungsmaterial (7) oder dessen Ausgangsmaterialien eingebracht wird
und
- **dass** der Querschnitt der so gefüllten Hülse (6) oder Buchse (9) reduziert wird.

11. Verfahren nach Anspruch 10, **dadurch gekennzeichnet, dass** die Endstücke mit dem supraleitfähigen MgB₂ und dem Barrierenmaterial (5) vor dem Einbringen in die Hülse (6) oder Buchse (9) angeschrägt werden, derart dass die Fläche der freiliegenden MgB₂ Verbindungsbereiche (8) vergrößert wird.

12. Verfahren nach Anspruch 10 oder 11, **dadurch gekennzeichnet, dass** die Verbindungsbereiche (8) zumindest teilweise geschliffen und/oder poliert werden.

13. Verfahren nach einem der Ansprüche 10 bis 13, **dadurch gekennzeichnet, dass** das Matrixmaterial (4) in einem Zinnbad entfernt wird, wobei die Leiteradern (3i) von dem Barrierematerial (5) ummantelt bleiben.

14. Verfahren nach einem der Ansprüche 10 bis 13, **dadurch gekennzeichnet, dass** das MgB₂-Kontaktierungsmaterial (7) oder dessen Ausgangsmaterialien in die Hülse (6) oder Buchse (9) in Pulverform eingebracht wird und gegebenenfalls einer Wärmebehandlung unterzogen wird.

15. Verfahren nach einem der Ansprüche 10 bis 14, **dadurch gekennzeichnet, dass** die gefüllte Hülse (6) oder Buchse (9) nach oder während der Querschnittsreduzierung einer Wärmebehandlung unterzogen wird, insbesondere bei einer Temperatur von unter 600°C, vorzugsweise unter 250°C, und insbesondere die Wärmebehandlung in Argon-Atmosphäre durchgeführt wird, wobei insbesondere die Hülse (6) oder Buchse (9) luft- und/oder wasserdicht versiegelt wird.

## Claims

1. Superconductive connecting device for the end pieces of at least two superconductors (2), each of which has a matrix (4) made of normally conductive material and at least one conductor lead (3i) made of superconductive MgB₂ (magnesium diboride) embedded therein, whereby in a connecting region (8) in a sleeve (6) or bushing (9)
- are arranged the conductor leads (3i) for the end pieces at least partially stripped of matrix material (4)
and
- MgB₂ or its base materials is/are additionally present as a superconductive contacting material (7) which is located at least in partial regions between the conductor leads (3i),
wherein
- the conductor leads (3i) are directly sheathed in each case with a barrier layer made of a barrier material (5) different from the matrix material (4),
and
- at least one end-face connecting region (8) is kept free of the barrier material (5) which surrounds the conductor leads (3i),
**characterised in that**
- the sheathing with the barrier layer is in each case present in a partial region of the end pieces of the conductor leads (3i) that have been stripped of matrix material (4).

2. Superconductive connecting device according to claim 1, **characterised in that** the end pieces with the superconductive MgB₂ and the barrier material (5) are bevelled.

3. Superconductive connecting device according to claim 1 or 2, **characterised by** operation at a temperature below the transition temperature of 39 K of the MgB₂ contacting material (7).

4. Superconductive connecting device according to claim 3, **characterised by** an operating temperature at the temperature of liquid helium of about 4.2 K.

5. Superconductive connecting device according to one of the preceding claims, **characterised in that** the matrix material (4) consists of copper or nickel, or that the matrix material (4) contains copper or nickel and/or the sleeve (6) or bushing (9) is sealed airtight and/or watertight.

6. Superconductive connecting device according to one of the preceding claims, **characterised in that** the barrier material (5) consists of steel or stainless steel or contains steel or stainless steel.

7. Superconductive connecting device according to one of the preceding claims, **characterised by** an association with a superconductive magnet winding of a magnet.

8. Superconductive connecting device according to claim 7, **characterised by** an association with a superconductive magnet winding of a magnet of a machine for magnetic resonance tomography.

9. Superconductive connecting device according to claim 7 or 8, **characterised by** an association with a superconductive magnet winding designed for persistent current operation.

10. Method for the production of a superconductive connecting device as claimed in one of the preceding claims, **characterised in**
- **that** the superconductive conductor leads (3i) are in each case stripped at least partially of their matrix material (4) at the end pieces to be connected,
- **that** the barrier material (5) is not removed during the stripping process,
- **that** in the connecting region (8) at least on the end faces of the end pieces to be connected the MgB₂ material of the conductor leads (3i) is or has been at least partially exposed,
- **that** the conductor leads (3i) stripped in this way are inserted into the sleeve (6) or bushing (9),
- **that** the MgB₂ contacting material (7) or its base materials is/are additionally inserted into the sleeve (6) or bushing (9)
and
- **that** the cross-section of the sleeve (6) or bushing (9) filled in this way is reduced.

11. Method according to claim 10, **characterised in that** prior to being inserted into the sleeve (6) or bushing (9) the end pieces with the superconductive MgB₂ and the barrier material (5) are bevelled in such a manner that the surface area of the exposed MgB₂ connecting regions (8) is increased.

12. Method according to claim 10 or 11, **characterised in that** the connecting regions (8) are at least partially ground and/or polished.

13. Method according to one of claims 10 to 13, **characterised in that** the matrix material (4) is removed in a tin bath, whereby the conductor leads (3i) remain sheathed by the barrier material (5).

14. Method according to one of claims 10 to 13, **characterised in that** the MgB₂ contacting material (7) or its base materials is/are inserted into the sleeve (6) or bushing (9) in powder form and where applicable is/are subjected to a heat treatment process.

15. Method according to one of claims 10 to 14, **characterised in that** the filled sleeve (6) or bushing (9) is subjected to a heat treatment process after or during the reduction in cross-section, in particular at a temperature of below 600°C, preferably below 250°C, and in particular the heat treatment process is carried out in an argon atmosphere, whereby in particular the sleeve (6) or bushing (9) is sealed airtight and/or watertight.

## Revendications

1. Dispositif supraconducteur de liaison des embouts d'au moins deux supraconducteurs ( 2 ), qui ont respectivement une matrice ( 4 ) en matériau normalement conducteur et au moins des brins ( 3i ) en MgB₂ ( diborure de magnésium ) supraconducteurs qui y sont incorporés, dans lequel, dans une partie ( 8 ) de liaison d'un manchon ( 6 ) ou d'une boîte ( 9 ),
- les brins ( 3i ) conducteurs des embouts sont dévêtus au moins en partie du matériau ( 4 ) de matrice
et
- supplémentairement, il y a comme matériau ( 7 ) supraconducteur de mise en contact, du MgB₂ ou ses matériaux de départ, qui se trouve au moins dans des zones partielles entre les brins ( 3i ) conducteurs,
dans lequel
- les brins 3i ) conducteurs sont gainés directement respectivement d'une couche formant barrière en un matériau ( 5 ) formant barrière, différent du matériau ( 4 ) de matrice,
et
- au moins une zone ( 8 ) de liaison du côté frontal est maintenue exempte du matériau ( 5 ) formant barrière, qui entoure les brins ( 3i ) conducteurs,
**caractérisé en ce que**
- le gainage par la couche formant barrière est présent respectivement dans une zone partielle des embouts, dévêtus du matériau ( 4 ) de matrice, des brins ( 3i ) conducteurs.

2. Dispositif supraconducteur de liaison suivant la revendication 1,
**caractérisé en ce que** les embouts ayant le ( MgB₂ ) supraconducteur et le matériau ( 5 ) formant barrière sont biseautés.

3. Dispositif supraconducteur de liaison suivant la revendication 1 ou 2, **caractérisé par** un fonctionnement à une température inférieure à la température critique de 39 K du matériau ( 7 ) de mise en contact de MgB₂.

4. Dispositif supraconducteur de liaison suivant la revendication 3, **caractérisé par** une température de fonctionnement à la température de l'hélium liquide d'environ 4,2 K.

5. Dispositif supraconducteur de liaison suivant l'une des revendications précédentes, **caractérisé en ce que** le matériau ( 4 ) de matrice est en cuivre ou en nickel ou **en ce que** le matériau ( 4 ) de matrice contient du cuivre ou du nickel et/ou **en ce que** le manchon ( 6 ) ou la boîte ( 9 ) sont scellés d'une manière étanche à l'air et/ou à l'eau.

6. Dispositif supraconducteur de liaison suivant l'une des revendications précédentes, **caractérisé en ce que** le matériau ( 5 ) formant barrière est en acier ou en acier fin ou contient de l'acier ou de l'acier fin.

7. Dispositif supraconducteur de liaison suivant l'une des revendications précédentes, **caractérisé par** une adjonction à un enroulement magnétique supraconducteur d'un aimant.

8. Dispositif supraconducteur de liaison suivant la revendication 7, **caractérisé par** une adjonction à un enroulement magnétique supraconducteur d'un aimant d'une installation de tomographie par résonance magnétique.

9. Dispositif supraconducteur de liaison suivant la revendication 7 ou 8, **caractérisé par** une adjonction à un enroulement magnétique supraconducteur, conçu pour un fonctionnement en courant permanent.

10. Procédé de fabrication d'un dispositif supraconducteur de liaison suivant l'une des revendications précédentes, **caractérisé,**
- **en ce que** sur les embouts à relier on dévêt les brins ( 3i ) conducteurs supraconducteurs, au moins en partie, de leur matériau ( 4 ) de matrice,
- **en ce que** l'on n'enlève pas le matériau ( 5 ) formant barrière lors de l'opération de dévêtissage,
- **en ce que**, dans la zone ( 8 ) de liaison, au moins sur les côtés frontaux des embouts à relier, on met à nu au moins en partie le matériau de MgB₂ des brins ( 3i ) conducteurs ou il est à nu.
- **en ce que** l'on met les brins 3i ) conducteurs ainsi dévêtus dans le manchon ( 3 ) ou dans la boîte ( 9 ),
- **en ce que** l'on met dans le manchon ( 6 ) ou dans la boîte ( 9 ) supplémentairement le matériau ( 7 ) de mise en contact de MgB₂ ou ses matériaux de départ
et
- **en ce que** l'on réduit la section transversale du manchon ( 6 ) ou de la boîte ( 9 ) ainsi remplie.

11. Procédé suivant la revendication 10, **caractérisé en ce que** l'on biseaute les embouts ayant le MgB₂ supraconducteur et le matériau ( 5 ) formant barrière avant la mise dans le manchon ( 6 ) ou dans la boîte ( 9 ) de manière à agrandir la surface des zones ( 8 ) de liaison de MgB₂ mises à nu.

12. Procédé suivant la revendication 10 ou 11, **caractérisé en ce que** l'on rode et/ou polit au moins en partie les zones ( 8 ) de liaison.

13. Procédé suivant l'une des revendications 10 à 13, **caractérisé en ce que** l'on élimine le matériau ( 4 ) de matrice dans un bain d'étain, les brins 3i ) conducteurs restant gainés par le matériau ( 5 ) formant barrière.

14. Procédé suivant l'une des revendications 10 à 13, **caractérisé en ce que** l'on met le matériau ( 7 ) de mise en contact de MgB₂ ou ses matériaux de départ sous forme de poudre dans le manchon ( 6 ) ou dans la boîte ( 9 ) et on le soumet, le cas échéant, à un traitement thermique.

15. Procédé suivant l'une des revendications 10 à 14, **caractérisé en ce que** l'on soumet à un traitement thermique le manchon ( 6 ) ou la boîte ( 9 ) rempli après ou pendant la réduction de la section transversale, notamment à une température inférieure à 600°C, de préférence inférieure à 250°C, et en effectuant notamment le traitement thermique dans une atmosphère d'argon, le manchon ( 6 ) ou la boîte ( 9 ) étant notamment scellé d'une manière étanche à l'air et/ou à l'eau.
